# EUROPEAN PATENT APPLICATION

(11) **EP 0 899 868 A1**
(43) Date of publication of application: **03.03.1999**
(21) Application number: 98306821.4
(22) Date of filing: 26.08.1998
(51) Int. Cl.: H03D 7/00

(54) **Modulated local oscillator**

(30) Priority: 28.08.1997 GB 9718100
(71) Applicant: MITEL CORPORATION, Kanata Ontario K2K 1X3 (CA)
(72) Inventor: Manku, Tajinder, Halifax, Nova Scotia B3S 1E2 (CA); MacEachern, Leonard, Ottawa, Ontario K1S 5Y3 (CA)
(74) Representative: Harding, Richard Patrick

(57) **Abstract**

A method of performing a frequency conversion of a radio frequency (RF) information signal by mixing the information signal with a modulated signal from local oscillator. The local oscillator signal is modulated with a periodic, coded or pseudo-random modulating signal. A system for generating an intermediate frequency (IF) output signal from the information signal is also provided.

## Description

### Field of the Invention

This invention relates to a system and method for performing frequency conversion of an information signal by mixing the signal with a modulated signal from a local oscillator.

### Background

Radio frequency receivers for a number of applications, such as in wireless communications, employ frequency conversion techniques in which an information carrying radio frequency (RF) signal is mixed with a signal generated by a local oscillator (LO) in order to generate an intermediate frequency (IF) signal. The frequency of the intermediate signal resulting from the frequency conversion may be higher or lower than the information carrying signal depending on the frequency of the local oscillator.

Typical direct conversion RF receivers are subject to problems associated with DC offsets and leakage between the RF and local oscillator as well as between the local oscillator and the receiver antenna.

The present invention provides a method of minimizing these problems by removing parasitic signals that otherwise deteriorate the performance of the wanted signal. The invention also relates to a method of removing unwanted DC offsets within the signal containing the data or information.

The modulated local oscillator signal according to the present invention may be used to overcome known problems associated with current receiver architectures. The modulated (for example, phase modulated) local oscillator (LO) is mixed or multiplied, either by using digital or analog methods with the information bearing signal using an arrangement of mixers or multipliers. Further signal processing, utilizing filters for example, may either remove unwanted signals or enhance the wanted signal in such a way that is difficult to achieve if no modulated local oscillator is used.

### Summary of the Invention

According to the present invention the frequency conversion (up or down) local oscillator is modulated with a locally generated signal which can either be coded, non-coded, periodic or pseudo-random.

Therefore, in accordance with a first aspect of the present invention there is provided a modulated local oscillator for signal frequency conversion comprising: first input means for receiving a periodic local oscillator signal; second input means for receiving a modulating signal; and output means for supplying a modulated local oscillator signal.

In accordance with a second aspect of the present invention there is provided a system for frequency converting an information signal containing data comprising: modulating means having a first input for receiving a local oscillator signal, a second input for receiving a modulating signal and output means for providing a modulated local oscillator signal; a mixer having a first mixer input for receiving the information signal and a second mixer input for receiving the modulated local oscillator signal; and output means for supplying a frequency converted intermediate signal.

In accordance with this aspect of the invention the information system is down converted.

In accordance with a further aspect of the invention there is provided a method of frequency converting an information signal containing data comprising the steps of: providing the information signal to a mixer; providing a modulated local oscillator signal to the mixer; and mixing the information signal and local oscillator signal to generate a frequency converted intermediate signal.

### Brief Description of the Drawings

The invention will now be described in greater detail with reference to the attached drawings wherein:
Figure 1 illustrates the basic frequency conversion system; and
Figure 2 is a system diagram for generating the phase modulated local oscillator signal.

### Detailed Description of the Invention

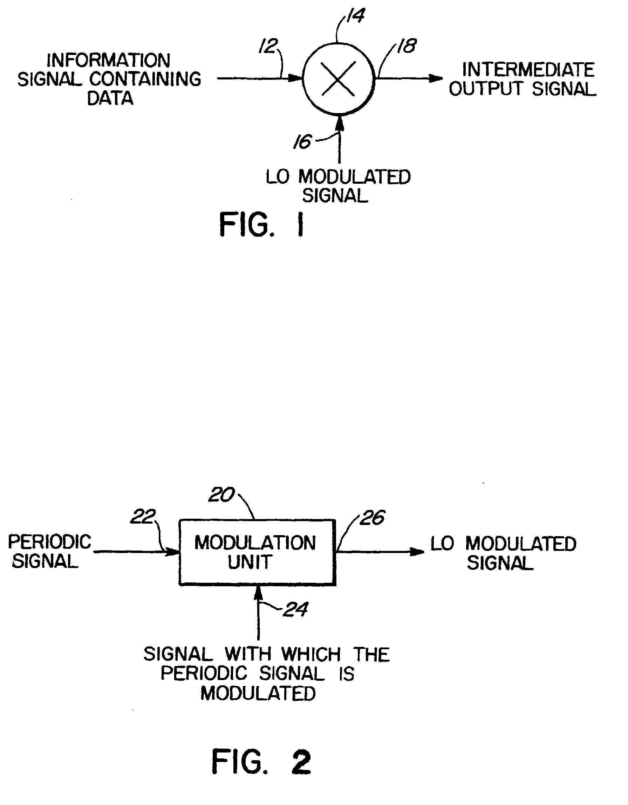

The basic system according to the present invention is illustrated in Figure 1. The input to the system consists of an information signal containing either digital or analog information. The input signal is provided to input 12 of mixer 14. Mixer 14 multiplies the input signal with a modulated locally produced oscillator signal via input 16. The resulting intermediate signal is delivered by output 18. The intermediate output signal may be further processed to either remove any unwanted signal components or to enhance the desired signal components.

The modulated local oscillator signal provided at input 16 is generated using a periodic signal combined with a signal which acts to modulate the periodic signal.

The system diagram for generating the modulated local oscillator is shown in Figure 2. As shown in Figure 2 modulation unit 20 receives via first input 22 a periodic signal which may be a square wave or a sine wave. Modulation unit 20 is also provided with a modulating signal (phase modulating, for example) via input 24. The signal provided at input 24 is either coded, non-coded, periodic or pseudo-random. The modulated local oscillator signal from output 26 is provided to input 16 of mixer 14 as previously discussed.

As indicated previously, the modulated local oscillator signal may be used to remove parasitic signals that deteriorate the performance of the wanted signal, or to remove unwanted DC offsets within the signal containing the data. It is also contemplated that the modulated local oscillator signal can be used to modulate the output signal using a coded modulation scheme. It may also be used to demodulate an encrypted or encoded signal in addition to its use in a direct conversion receiver architecture or for use in a scanning spectrum analyzer.

In general the structure may be used to remove unwanted signal components in a RF receiver. Furthermore, the structure may be used to enhance the wanted signal in a RF receiver. In addition the structure may find similar application in a transmitter design.

It is also contemplated that depending upon the signal used to modulate the local oscillator the mixer 14 may be used to perform a function other than multiplication such as sign inversion. Other possible applications for the modulated local oscillator are applications requiring high levels of image rejection and receiver architectures requiring high levels of integration such as mobile telecommunications devices.

Although one particular embodiment of the present invention has been described and illustrated it will be apparent to one skilled in the art that various alternatives can be introduced. It is to be understood that such variations will fall within the scope of the invention as defined by the appended claims.

## Claims

1. A modulated local oscillator for signal frequency conversion, comprising: first input means for receiving a periodic local oscillator signal; second input means for receiving a modulating signal; and output means for supplying a modulated local oscillator signal.

2. A modulated local oscillator as defined in claim 1 wherein said modulating signal is a coded signal.

3. A modulated local oscillator as defined in claim 1 wherein said modulating signal is a non-coded signal.

4. A modulated local oscillator as defined in claim 1 wherein said modulating signal is a periodic signal.

5. A modulated local oscillator as defined in claim 1 wherein said modulating signal is a pseudo-random signal.

6. A modulated local oscillator as defined in claim 1 wherein said modulating signal is phase modulated.

7. A system for frequency converting an information signal containing data comprising: modulating means having a first input for receiving a local oscillator signal, a second input for receiving a modulating signal and output means for providing a modulated local oscillator signal; a mixer having a first mixer input for receiving said information signal and a second mixer input for receiving said modulated local oscillator signal; and output means for supplying a frequency converted intermediate signal.

8. A system as defined in claim 7 wherein said modulating means performs sign inversion.

9. A system as defined in claim 7 wherein said modulating means is a multiplier.

10. A method of frequency converting an information signal containing data comprising the steps of: providing said information signal to a first input of a mixer; providing a modulated local oscillator signal to a second input of said mixer; and mixing said information signal and said modulated local oscillator signal to generate a frequency converted intermediate signal.

11. A method as defined in claim 10 wherein said information signal is a radio frequency (RF) signal.

12. A method as defined in claim 10 wherein said frequency converted intermediate signal is down converted.

13. A method as defined in claim 10 wherein said modulated local oscillator signal is phase modulated.
